# EUROPÄISCHE PATENTANMELDUNG

(11) **EP 3 527 422 A1**
(43) Veröffentlichungstag der Anmeldung: **21.08.2019**
(21) Anmeldenummer: 18020512.2
(22) Anmeldetag: 18.10.2018
(51) Int. Cl.: B60L 53/14, B60L 53/31, B60L 53/53, B60L 53/302

(54) **LADESYSTEM MIT INTEGRIERTEM KÜHLMITTELSPEICHER**

(30) Priorität: 20.02.2018 DE 102018103706
(71) Anmelder: Dr. Ing. h.c. F. Porsche AG, 70435 Stuttgart (DE)
(72) Erfinder: Heyne, Raoul, 38640 Goslar (DE); Joslowski, Florian, 70771 Leinfelden-Echterdingen (DE)

(57) **Zusammenfassung**

Es wird ein Ladesystem zum Laden eines Elektrofahrzeugs bereitgestellt, welches eine Ladestation, mindestens einen Ladeanschluss, welcher zum Laden des Elektrofahrzeugs mit diesem koppelbar ist, einen Pufferspeicher zum Speichern von Energie, eine Leistungselektronik, welche eingerichtet ist, die Energie aus dem Pufferspeicher und/oder aus einem Netzanschluss der Ladestation an dem mindestens einen Ladeanschluss bereitzustellen, und einen Kältemittelspeicher aufweist, in welchem ein Kältemittel gespeichert ist, wobei das Kältemittel zum Kühlen der Leistungselektronik verwendet wird.

## Beschreibung

Die vorliegende Erfindung betrifft im Allgemeinen ein Ladesystem mit einem integrierten Kühlmittelspeicher. Bei dem Ladesystem kann es sich insbesondere um ein Ladesystem mit einem inkludierten elektrischen Pufferspeicher zum Laden von Elektrofahrzeugen und einem Speicher für ein flüssiges Kühlmittel handeln.

Der Elektromobilität ist in den letzten Jahren eine immer größer werdende Bedeutung zugekommen. Um die Verbreitung von Elektrofahrzeugen voranzubringen, ist es wünschenswert, dass der Ladevorgang eines Elektrofahrzeuges schnell, unkompliziert und jederzeit möglich ist. Heutzutage können moderne Elektrofahrzeuge mit Ladeleistungen jenseits von 100 kW geladen werden, mit Ladeströmen im Bereich von 300 Ampere und mehr. Die Leistungselektronik in der Ladestation führt die Umformung des Stroms und der Spannung aus einem Netzanschluss durch, so dass der Strom und die Spannung an den Ladesteckern die geeignete Form (DC oder AC) und Größe aufweisen, um ein Elektrofahrzeug aufladen zu können. Bei den während des Ladevorgangs auftretenden hohen Ladeströmen ist eine Kühlung der Leistungselektronik unerlässlich, da ansonsten bei höheren Außentemperaturen und insbesondere bei sich häufenden Ladevorgängen die Leistungselektronik durch Überhitzung beschädigt werden kann mit offensichtlich nachteiligen Konsequenzen für die Betreiber- und Benutzerseite.

Bei den zahlreichen unterschiedlichen Ladestationen, die weltweit im Einsatz sind, kommen verschiedenste Kühlsysteme zum Einsatz. Entsprechend variiert der Aufbau und die Auslegung der Kühlungseinheiten. Bei den meisten heutigen Ladesäulen wird die Leistungselektronik luftgekühlt. Eine gut funktionierende Luftkühlung kann jedoch nur implementiert werden, wenn der Bauraum der Ladesäule relativ groß ist und genügend Platz für eine entsprechende Luftstromführung vorhanden ist.

Eine Alternative zu einer Luftkühlung stellt eine Flüssigkeitskühlung dar, bei der anstatt Luft eine Flüssigkeit das die Wärme aufnehmende Medium darstellt. Aufgrund der meist deutlich höheren spezifischen Wärmekapazität kann eine Flüssigkeitskühlung kompakter ausfallen und dennoch eine hohe Kühlleistung bereitstellen. Gängige Flüssigkeitskühlungen sind meistens mit einem Wärmetauscher und einem Überdruckgefäß ausgestattet. Letzteres stellt sicher, dass bei Temperatur- und damit verbundenen Dichteschwankungen der Kühlflüssigkeit stets genügend Kühlflüssigkeit und auch des Kühlsystems im Kühlkreislauf vorhanden ist.

So wird in Druckschrift US 2012/043935 eine Ladesäule mit einer darin angeordneten Kühlvorrichtung beschrieben, die während des Ladens Kühlflüssigkeit an das Fahrzeug überträgt, um die Fahrzeugbatterie zu kühlen. In Druckschrift US 2013/307477 ist ein Behälter offenbart, welcher alle elektrischen Komponenten aufweist, die zur Ausführung des Ladevorgangs benötigt werden. Der Behälter ist derart konfiguriert, dass wärmeemittierende Elemente, d. h. insbesondere die elektrischen und elektronischen Komponenten, ihre Wärme an die Behälterwand übertragen. Druckschrift
US 2015/054460 offenbart eine Ladesäule mit einer Batterie zum Schnellladen eines Elektrofahrzeugs. Die Ladesäule beinhaltet ein mit Flüssigkeit betriebenes Temperierungssystem, wodurch zum einen eine Kühlung zum Fahrzeug bzw. zu dessen Batterie realisiert wird und zum anderen auch eine Kühlung der internen Batterie zum Schnellladen vorgenommen wird. In Druckschrift CN 206344701 wird eine Ladesäule mit einem Kühlungssystem beschrieben, welches eine über dem externen Gehäuse der Ladesäule eingeordnete Solarzelle mit Wassertank aufweist. Zur Kühlung der Ladesäule wird Wasser über das Außengehäuse der Ladesäule gesprüht. Zusätzlich wird eine Fernüberwachung der Temperatur und der Luftfeuchte vorgeschlagen. Schließlich beschreibt Druckschrift DE 10 2015 222703 eine Ladestation, die neben der elektrischen Energiebereitstellung auch eine fluidbasierte Temperiervorrichtung aufweist zur Temperierung des Energiespeichers des Kraftwagens.

Ausgehend von Ladesäulen für Elektrofahrzeuge, die aus dem Stand der Technik bekannt sind, kann die Aufgabe der vorliegenden Erfindung darin gesehen werden, eine Ladestation mit einem effizienten und über mehrere Ladevorgänge hinweg Kälte bereitstellenden Kühlsystem bereitzustellen, das zudem möglichst leise ist, so dass die Benutzer während eines Ladevorgangs nicht übermäßig durch Lärm gestört werden.

Die Aufgabe wird durch ein Ladesystem gemäß Patentanspruch 1 gelöst. Vorteilhafte Weiterbildungen ergeben sich aus den abhängigen Patentansprüchen und der beiliegenden Beschreibung.

Erfindungsgemäß wird ein Ladesystem zum Laden eines Elektrofahrzeugs bereitgestellt, welches eine Ladestation, mindestens einen Ladeanschluss, welcher zum Laden des Elektrofahrzeugs mit diesem koppelbar ist bzw. an dieses angeschlossen werden kann, einen Pufferspeicher zum Speichern von Energie, eine Leistungselektronik, welche eingerichtet ist, die Energie aus dem Pufferspeicher und/oder aus einem Netzanschluss der Ladestation an dem mindestens einen Ladeanschluss bereitzustellen, und einen Kältemittelspeicher aufweist, in welchem ein Kältemittel gespeichert ist, wobei das Kältemittel zum Kühlen der Leistungselektronik verwendet wird.

Das erfindungsgemäße Ladesystem kann generell als ein modulares System vorliegen und eine Ladestation und mindestens eine davon getrennte Ladesäule aufweisen, welche einen oder mehrere Ladestecker aufweisen kann. Alternativ kann das Ladesystem als ein kombiniertes System eingerichtet sein und ein Hauptgehäuse aufweisen, in dem sich die Leistungselektronik, der Pufferspeicher und der Kältemittelspeicher befinden, wobei der mindestens eine Ladestecker an dem Hauptgehäuse angeordnet sein kann. Bei dem Pufferspeicher kann es sich um eine geeignet dimensionierte wiederaufladbare Batterie bzw. Batterieanordnung handeln, welche die zur Ausführung der Ladevorgänge erforderliche Energie bereitstellt. Die Kapazität des Pufferspeichers kann, pro Ladestecker, im Bereich von ca. 50 kWh bis ca. 500 kWh liegen. Insbesondere kann der Pufferspeicher derart ausgelegt sein, dass an dem erfindungsgemäßen Ladesystem Kraftfahrzeuge mit Ladeleistungen geladen werden können, welche die Leistung des an das Ladesystem angeschlossenen Stromnetzanschlusses übersteigen. Gegebenenfalls kann für einen Ladevorgang nur die im Pufferspeicher vorliegende Energie verwendet werden, also ohne, dass der Ladevorgang zum Ladezeitpunkt auf einen Energiefluss aus dem Stromnetzanschluss angewiesen ist. Der Pufferspeicher kann also als Energiepuffer fungieren und so Ladevorgänge mit höheren Leistungen als die des Stromnetzanschlusses ermöglichen. Der Pufferspeicher kann jedoch auch als Energiespeicher fungieren und die gesamte während eines Ladevorgangs übertragene Energie bereitstellen. Die Ladevorgänge an dem erfindungsgemäßen Ladesystem sind damit unabhängig von der Leistung des angeschlossenen Stromnetzes. Die in dem Ladesystem angeordnete Leistungselektronik regelt die Stromwandlung (Stromstärke, Stromspannung und ggfs. Stromart (DC oder AC)) zwischen Pufferspeicher (oder ggfs. Stromnetzanschluss) und Ladestecker(n) des Ladesystems. Über den Netzanschluss kann das Ladesystem an das Stromnetz angeschlossen sein. Das erfindungsgemäße Ladesystem kann im Allgemeinen derart eingerichtet sein, dass daran Fahrzeuge mittels Strom aus dem Stromnetz und mittels Strom aus dem Pufferspeicher geladen werden können, wobei die Anteile der Ströme bei einem stattfindenden Ladevorgang von jeder der beiden Quellen zwischen 0% und 100% betragen können.

Die Ladestation des erfindungsgemäßen Ladesystems weist ferner einen Kältemittelspeicher auf, in welchem das zum Kühlen der Leistungselektronik verwendete Kühlmittel bereitgestellt ist. Der Kältemittelspeicher ist innerhalb des Ladesystems angeordnet und an ein fluidmechanisches Temperiersystem gekoppelt, beispielsweise an ein Rohrleitungssystem mit Kühlkörpern, so dass insgesamt ein vollwertiges aktives Kühlsystem vorliegt, um die in Wärme umgesetzte Verlustleistung aus der Leistungselektronik abzuführen. Das fluidmechanische Temperiersystem kann weitere, in einem Kühlmittelkreislauf übliche Bauteile aufweisen wie z.B. eine Pumpe, einen Radiator und einen Ausgleichsbehälter. Die Kühlung der Leistungselektronik kann im Allgemeinen direkt mittels an die Leistungselektronikelemente angebrachter Kühlelemente und/oder indirekt mittels eines Wärmetauschers erfolgen, welcher am Ort der Leistungselektronik angeordnet ist und die die Leistungselektronik umströmende Luft abkühlt.

Durch eine passende Auslegung des Kältemittelspeichers kann das erfindungsgemäße Ladesystem mit genügend Kühlleistung ausgestattet sein, um auch bei warmen Außentemperaturen sicher und zuverlässig zu arbeiten. Die Kühlleistung wird nicht ausschließlich aus einem stärkeren Wärmeaustausch mit der Umgebung bezogen, sondern auch aus dem Temperaturgradienten zwischen Kältemittel und dem zu kühlenden Bauteil. Es kann so eine relativ geräuscharme Kühlung realisiert werden, die z.B. auf kaum hörbaren, da mit niedrigen Drehzahlen betriebenen, Luftgebläsen basiert. Es kann auch die Erzeugung sehr heißer Abwärme (Abluft) vermieden werden, die unmittelbar aus der Ladestation ausgestoßen wird, wenn mehrere Ladevorgänge hintereinander und/oder parallel zueinander stattfinden und somit mehr Abwärme abgeführt werden muss oder wenn die Außentemperatur ansteigt. Durch eine gute thermische Entkopplung des Kältemittelspeichers von der Außenumgebung kann das Kältemittel beispielsweise mit einer konstanten Rate abgekühlt werden, beispielsweise mittels eines belüfteten Kondensators. Der Kältemittelspeicher kann insofern als Puffer für Abwärmespitzen betrachtet werden und ermöglicht daher die Verwendung eines insgesamt kleiner dimensionierten übrigen Teils des Kühlsystems (im Vergleich zu einem Kühlsystem ohne den Kältemittelspeicher), mittels welchem die Abwärme aus dem Ladesystem an die Umgebung abgegeben wird. Anders ausgedrückt sorgt der Kältemittelspeicher dafür, dass bei abwechselnder Nutzung und Nicht-Nutzung des erfindungsgemäßen Ladesystems die Kühlung der Leistungselektronik kontinuierlich geglättet erfolgt. Der Kältemittelspeicher kann also als ein Körper betrachtet werden, welcher eine in Relation zur anfallenden Abwärme während eines Ladevorgangs eines Elektrofahrzeugs große Wärmemenge aufnehmen kann. Die Abwärme des Ladesystems wird aufgenommen und sozusagen dosiert an die Umgebung abgegeben. Bei geeigneter Auslegung bietet der Kältemittelspeicher zudem genügend Aufnahmekapazität für abzuführende Wärme, so dass auch zeitlich versetzt ausreichend Kühlleistung zur Verfügung gestellt werden kann. Darunter kann unter anderem gemeint sein, dass nicht nur zu Beginn eines Ladevorgangs die gesamte Kühlleistung zur Verfügung steht, sondern der Kältemittelspeicher bei weiteren bzw. nachfolgenden Ladevorgängen ebenfalls noch Kühlleistung bereitstellen kann. Ist beispielsweise das Ladesystem mit maximal 10 kW Kühlleistung auszustatten, so kann der Kühlmittelspeicher beispielsweise für 4 kW Kühlleistung ausgelegt sein, so dass das übrige Kühlsystem, welches klassisch die Abluft der Leistungselektronik an die Umgebung abführt, nur noch für 6 kW anstatt für 10 kW ausgelegt werden muss. Der Kältemittelspeicher kann dann beispielsweise in Ruhephasen "regeneriert" werden, also wieder auf seine Grundtemperatur abgekühlt werden. Unter einer Ruhephase kann eine Phase verstanden werden, in denen keine oder nur sehr wenig Abwärme aus der Ladestation abgeführt werden muss. Insbesondere könnten während der Nacht vermehrt Ruhephasen vorliegen, da hier zum einen üblicherweise weniger Ladevorgänge stattfinden und auch die Außentemperatur im Vergleich zum Tag abnimmt, so dass die Abgabe von Wärme an die Außenumgebung mittels Wärmetauscher effizienter verläuft. In diesem Sinne kann also der Kältemittelspeicher als Glättungselement gesehen werden: Bei hoher Ladelast an dem Ladesystem kann es Kühlleistung bereitstellen und bei niedriger Ladelast an dem Ladesystem kann es wieder regeneriert werden.

Gemäß einer weiteren Ausführungsform des Ladesystems kann das Kältemittel zusätzlich auch zum Kühlen des Pufferspeichers verwendet werden. Der Pufferspeicher kann also in gleicher Weise wie die Leistungselektronik gekühlt werden. Die Kühlung des Pufferspeichers kann direkt mittels an den Pufferspeicher angebrachter Kühlelemente oder indirekt mittels eines Wärmetauschers erfolgen, welcher nahe bzw. im Bereich des Pufferspeichers angeordnet ist und die den Pufferspeicher umströmende Luft abkühlt.

Gemäß einer weiteren Ausführungsform kann das Ladesystem ferner mindestens eine Ladesäule aufweisen, welche mit der Ladestation elektrisch gekoppelt ist, wobei der mindestens eine Ladeanschluss an der Ladesäule bereitgestellt ist. Die Ladesäule kann mittels einer Leitung mit der Ladestation elektrisch gekoppelt sein und getrennt davon in einem Abstand davon (beispielsweise 50 Meter oder 100 Meter) aufgestellt sein. In einer weiteren Ausführungsform kann die Ladesäule auch thermisch mit der Ladestation verbunden sein, sodass das Kühlsystem der Ladestation die Kühlung der Ladesäule übernimmt. Eine solche Ausführungsform kann den Vorteil haben, dass die Ladesäule sehr kompakt und unauffällig aufgebaut werden kann, da die Leistungselektronik und der Pufferspeicher zentral in der Ladestation angeordnet sind. Die Ladesäule kann dann sozusagen einzig den Ladestecker und ein Bedienterminal aufweisen. In einer besonders geeigneten Ausführungsform kann die Ladesäule zusätzlich einen Wärmetauscher aufweisen, der die Kühlung von der Ladestation an einen separaten Kühlkreislauf für das Ladekabel überträgt, damit weniger Spezialkühlmittel für diesen Kühlkreislauf verwendet werden kann.

Gemäß einer weiteren Ausführungsform des Ladesystems kann es sich bei dem Kältemittel um Wasser handeln. Folglich kann der Kältemittelspeicher einen Wassertank aufweisen. Dem verwendeten Wasser können diverse Additive zugesetzt sein, welche die Funktionalität des Wassers erhöhen, beispielsweise ein Korrosionsschutz und/oder ein Frostschutz.

Gemäß einer weiteren Ausführungsform des Ladesystems kann der Kältemittelspeicher unterhalb der Erdoberfläche angeordnet sein. Eine unterirdische Installation des Kältemittelspeichers kann diesen vor Sonneneinstrahlung schützen und insgesamt den mittelnden bzw. temperierenden Effekt des Erdbodens (d.h. im Sommer kühler als übliche Lufttemperaturen (z. B. 30°C) und im Winter wärmer als übliche Lufttemperaturen (z.B. - 5°C)) ausnutzen. Die Ladestation des erfindungsgemäßen Ladesystems kann beispielsweise einen oberirdischen Teil und einen unterirdischen Teil aufweisen, wobei der unterirdische Teil vom oberirdischen Teil überwiegend thermisch isoliert sein kann. Der unterirdische Teil und der oberirdische Teil können baulich eine Einheit ausbilden oder aber auch baulich voneinander getrennt sein und nur durch entsprechende Kühlmittelrohre bzw. Teile des Flüssigkeitskühlsystems und Stromleitungen miteinander verbunden sein. Im oberirdischen Teil kann der Pufferspeicher in Form einer Batterieanordnung angeordnet sein. In einer weiteren Ausführungsform kann jedoch auch mindestens ein Teil des Pufferspeichers der Ladestation unterirdisch installiert sein, um die klimatisierende Wirkung des Erdbodens auch für diesen Teil auszunutzen. Der unterirdische Teil der erfindungsgemäßen Ladestation weist also mindestens den Kältemittelspeicher auf und kann ferner zweckmäßigerweise auch fluidmechanische Elemente des Kühlmittelkühlsystems, wie z.B. einen Kompressor und/oder Pumpen, und gegebenenfalls mindestens einen Teil des Pufferspeichers aufweisen. Im oberirdischen Teil der Ladestation können Lüfter vorgesehen sein, welche dem Flüssigkeitskühlsystem zugeordnet sind und einen Wärmeübertrag aus einem Kondensator des Kühlsystems an die Umgebung unterstützten.

Gemäß einer weiteren Ausführungsform des Ladesystems kann der Ladeanschluss eine Kältemittelleitung aufweisen, welche direkt oder indirekt über einen Wärmetauscher mit dem Kältemittelspeicher gekoppelt ist, zur aktiven Kühlung des Ladeanschlusses, insbesondere während eines stattfindenden Ladevorgangs. Das bedeutet, dass die Kühlmittelleitung innerhalb des Ladeanschlusses, d.h. innerhalb des Ladekabels, welches einen Ladestecker (wobei der Ladestecker selbst auch gekühlt werden kann) mit der Ladestation oder der Ladesäule verbindet, nicht isoliert ist, sondern für einen Wärme- bzw. Kälteübergang zwischen der Kühlmittelleitung und den in dem Ladeanschluss verlaufenden Ladestromkabeln ausgelegt ist. Bei der Kältemittelleitung kann es sich um keine überwiegend nicht isolierte Transportleitung handeln, welche nicht ausschließlich zum Transport des Kältemittels vom Kältemittelspeicher zum Kühlsystem des Elektrofahrzeugs dient, wie aus dem Stand der Technik bekannt.

Gemäß einer weiteren Ausführungsform des Ladesystems kann der Kältemittelspeicher ein Fassungsvermögen in der Größenordnung von ungefähr 200 Litern oder mehr pro Ladeanschluss aufweisen. Dadurch kann der Kältemittelspeicher genügend Kühlleistung bereitstellen und als primäre Kühlquelle für den Pufferspeicher und die Leistungselektronik dienen.

Gemäß einer weiteren Ausführungsform des Ladesystems kann das Kühlsystem auch als Heizsystem betrieben werden und bei Bedarf die in Relation zur Umgebungstemperatur im Kältemittelspeicher gespeicherte Energie in Form von Wärme an Komponenten des Ladesystems abgeben. Beispielsweise kann so im Winter das Ladekabel erwärmt werden, so dass es biegsam bleibt. Insofern kann das Kühlsystem als Temperiersystem betrachtet werden, welches übermäßig kalten und übermäßig heißen Temperaturen der damit temperierbaren Bauteile vorbeugen kann.

Weitere Vorteile und Ausgestaltungen der Erfindung ergeben sich aus der Beschreibung und den beiliegenden Zeichnungen.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Die Erfindung ist anhand von Ausführungsformen in den Zeichnungen schematisch dargestellt und wird unter Bezugnahme auf die Zeichnungen schematisch und ausführlich beschrieben.
Figur 1 zeigt eine schematische Ansicht eines Ladesystems gemäß verschiedenen Ausführungsbeispielen.
Figur 2 zeigt eine Ausführungsform der Ladestation des erfindungsgemäßen Ladesystems.

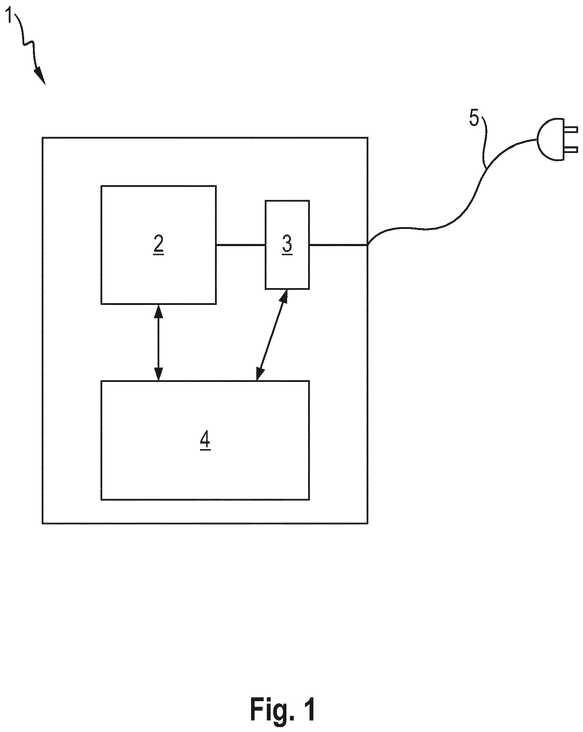

In Figur 1 ist eine schematische Ansicht eines Ladesystems 1 gemäß verschiedenen Ausführungsbeispielen gezeigt. Das Ladesystem weist eine Ladestation 1 mit einen Pufferspeicher 2 zum Speichern von Energie. Ferner ist in der Ladestation 1 eine Leistungselektronik 3 angeordnet, worunter alle elektrischen und elektronischen Bauteile zusammengefasst gemeint sind, welche an der Bereitstellung der Energie aus dem Pufferspeicher 2 und/oder dem Netzanschluss zum Laden eines Elektrofahrzeugs beteiligt sind. Die Ladestation 1 weist ferner eine Leistungselektronik 3 auf, welche unter Anwendung einer erforderlichen Spannungs- und ggfs. Stromwandlung einen Ladestrom bereitstellt, mittels welchem ein über einen Ladeanschluss 5 an die Ladestation 1 angeschlossenes Elektrofahrzeug geladen werden kann. Obgleich in Figur 1 nur ein Ladeanschluss 5 gezeigt ist, können selbstverständlich mehr Ladeanschlüsse bereitgestellt werden. Zudem kann der mindestens eine Ladeanschluss 5 statt direkt an der Ladestation 1 auch an einer von der Ladestation 1 entfernt aufgestellten Ladesäule angeordnet sein, welche mit der Ladestation 1 elektrisch gekoppelt ist und an der die Abgabe des Ladestroms erfolgt.

Die erfindungsgemäße Ladestation 1 weist ferner einen Kältemittelspeicher 4 auf, welcher bevorzugt unterirdisch installiert ist. In dem Kältemittelspeicher 4 ist ein Kältemittel gespeichert, z. B. Wasser, welches zum Kühlen der Leistungselektronik 3 und auch bevorzugt des Pufferspeichers 2 verwendet werden kann. Der Kühlvorgang ist durch die in Figur 1 gezeigten Doppelpfeile angedeutet und kann im Wesentlichen ein Kühlsystem repräsentieren, welches auf Basis des Kältemittels aus dem Kältemittelspeicher 4 eine Kühlung des Pufferspeichers und der Leistungselektronik vornimmt. Wie bereits erläutert kann die Kühlung der entsprechenden Systeme direkt oder indirekt erfolgen.

Unter einer unterirdischen Anordnung des Kältemittelspeichers 4 kann beispielsweise eine Versenkung des Kältemittelspeichers 4 bzw. des Gehäuse- oder Gebäudeteils der Ladestation 1 im Erdboden am Aufstellungsort der Ladestation 1 gemeint sein, welcher den Kältemittelspeicher 4 aufweist. Das Kühlsystem, welches durch die beiden Doppelpfeile repräsentiert ist, kann zusätzlich dazu verwendet werden, das Ladekabel des Ladeanschlusses 5 zu kühlen.

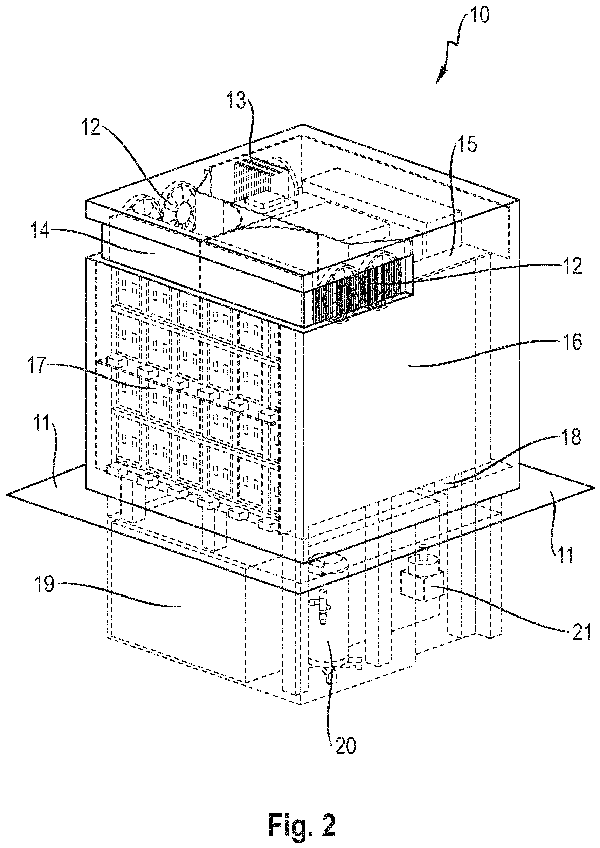

In Figur 2 ist eine konkrete beispielhafte Implementierung der Ladestation 10 des erfindungsgemäßen Ladesystems gezeigt. Je nach Anzahl und Dimension der Komponenten im Inneren der Ladestation 10 kann ihre Größe variieren. Eine beispielhafte Grundfläche der Ladestation 10 kann im Bereich von etwa 1 bis etwa 10 m² liegen und eine beispielhafte Gesamthöhe (d.h. inklusive eines potentiellen unterirdischen Teils) kann im Bereich von etwa 1 bis etwa 4 m liegen. Die Ladestation 10 kann am Aufstellungsort beispielsweise zur Hälfte im Erdboden angeordnet sein. Die in Figur 2 dargestellte beispielhafte Ladestation 10 weist eine Quaderform auf, was kein zwingendes Erfordernis darstellt. Im oberen Teil der Ladestation 10 können Lüfter 12 angeordnet sein, welche für eine Luftumwälzung in einem Bereich der Ladestation 10 sorgen, in dem der Kondensator 14 des Kühlsystems angeordnet ist. In dem Kondensator 14 wird das gasförmige, überhitzte Kältemittel abgekühlt. Im oberen Bereich der Ladestation 10 kann ferner ein erster Wärmetauscher 13 angeordnet sein, bei dem es sich um einen Flüssigkeit-Luft-Wärmetauscher der Leistungselektronik (in Figur 2 ist die Leistungselektronik nicht explizit dargestellt) handelt. Mittels des ersten Wärmetauschers 13 wird der durch die Leistungselektronik im Inneren der Ladestation 10 erwärmten Luft Wärme entzogen und auf das Kältemittel übertragen. Ein Ausstoß heißer Abluft, die direkt von der Leistungselektronik erhitzt worden ist, aus der Ladestation 10 erfolgt nicht. Insbesondere dient der von den Lüftern 12 erzeugte Luftstrom nicht zur Durchlüftung des Bereiches der Ladestation 10, in welchem die Leistungselektronik angeordnet ist. Wie in Figur 2 dargestellt ist der Bereich, welcher die Leistungselektronik aufweist, durch eine Trennwand von dem Bereich getrennt, in welchem sich der Kondensator 14 des Kühlsystems befindet. Somit erfolgt die Kühlung der Leistungselektronik mittels der Flüssigkeitskühlung und nicht durch Ausstoß heißer Abluft aus der Ladestation 10. Zusätzlich zum ersten Wärmetauscher 13 können selbstverständlich mit dem Kühlsystem gekoppelte Kühlkörper vorgesehen sein, welche unmittelbar an besonders von Überhitzung betroffene Komponenten der Leistungselektronik angebracht sind. Die Leistungselektronik kann zusätzlich mittels einer Kühlplatte 15 gekühlt werden, die ihrerseits über Konvektion oder mittels eines Kühlkörpers gekühlt werden kann.

Im mittleren Bereich der beispielhaften Ladestation 10 ist der Pufferspeicher 17 angeordnet. Der Pufferspeicher 17 kann eine Anordnung von Batteriezellen und/oder Batteriemodulen aufweisen. Ferner ist seitlich der Batterieanordnung des Pufferspeichers 17 ein Bereich 16 für Verrohrung bereitgestellt, in dem beispielsweise Leitungen und Komponenten des Kühlsystems angeordnet sein können (diese sind nicht explizit dargestellt). Diese Komponenten können dazu dienen, das Kältemittel aus dem Kältespeicher 19 zur Leistungselektronik und bevorzugt zum Pufferspeicher 17 zu befördern und dann wieder zurück zum Kältemittelspeicher 19 zu führen. Der Bereich 16 kann von außen über eine Tür oder durch Klappen einer Haube für Fachpersonal zwecks Wartung zugängig sein. Im Bereich des Pufferspeichers 17 ist ein zweiter Wärmetauscher 18 angeordnet, bei dem es sich um einen Kältemittel-Luft-Wärmetauscher des Pufferspeichers 17 handelt. Mittels des zweiten Wärmetauschers 18 wird der durch den Pufferspeicher 17 im Inneren der Ladestation 10 erwärmten Luft Wärme entzogen und auf das Kältemittel übertragen. Ein unmittelbarer Ausstoß heißer, aus dem Pufferspeicher 17 stammender Luft aus der Ladestation 10 erfolgt dann nicht bzw. kann zeitlich versetzt zum Aufkommen der heißen Abluft erfolgen. Alternativ kann die Kühlung des Pufferspeichers 17 zusätzlich oder ausschließlich mittels einer Luftkühlung realisiert sein. Im unteren Bereich der Ladestation 10 ist der Kältemittelspeicher 19 angeordnet, beispielsweise ein Wassertank. Ferner ist ein Kompressor 20 vorgesehen sowie mindestens eine Pumpe 21. Das Flüssigkeitskühlsystem kann jeweils einen getrennten Kühlungsast für den Pufferspeicher 17, die Leistungselektronik und den Ladeanschluss 5 aufweisen. Folglich kann jeder dieser Kühlungsäste eine eigene Pumpe 21 zum Befördern des Kältemittels aufweisen. Die Kühlungsäste können jedoch auch beliebig zusammengeführt sein. Wie in Figur 2 dargestellt, befindet sich der untere Teil der Ladestation 10, welcher im Wesentlichen den Kältemittelspeicher 19 aufweist, unterhalb der Erdoberfläche 11 und ist somit vom Erdboden umgeben, welcher die Rolle einer thermisch isolierenden/stabilisierenden Masse übernimmt. Insbesondere ist der Kältemitteltank 19 bei einer Anordnung im Erdboden vor einer direkten Einwirkung der Sonnenstrahlung geschützt. Bei Bedarf kann der untere Teil der Ladestation 10 von dieser abgetrennt werden und tiefer im Erdboden angeordnet werden, um die Kühlungs- bzw. Temperierungswirkung des Erdbodens noch stärker auszunutzen.

## Patentansprüche

1. Ladesystem zum Laden eines Elektrofahrzeugs, aufweisend:
eine Ladestation;
mindestens einen Ladeanschluss, welcher zum Laden des Elektrofahrzeugs mit diesem koppelbar ist;
einen Pufferspeicher zum Speichern von Energie;
eine Leistungselektronik, welche eingerichtet ist, die Energie aus dem Pufferspeicher und/oder aus einem Netzanschluss der Ladestation an dem mindestens einen Ladeanschluss bereitzustellen; und
einen Kältemittelspeicher, in welchem ein Kältemittel gespeichert ist, wobei das Kältemittel zum Kühlen der Leistungselektronik verwendet wird.

2. Ladesystem gemäß Anspruch 1
wobei das Kältemittel zum Kühlen des Pufferspeichers und/oder direkt oder indirekt über einen Wärmetauscher zum Kühlen des Ladekabels verwendet wird.

3. Ladesystem gemäß Anspruch 1 oder 2, ferner aufweisend:
eine Ladesäule, welche mit der Ladestation elektrisch gekoppelt ist, wobei der mindestens eine Ladeanschluss an der Ladesäule bereitgestellt ist.

4. Ladesystem gemäß einem der Ansprüche 1 bis 3,
wobei das Kältemittel Wasser aufweist.

5. Ladesystem gemäß einem der Ansprüche 1 bis 4,
wobei der Kältemittelspeicher unterhalb der Erdoberfläche angeordnet ist.

6. Ladesystem gemäß Anspruch 1 bis 5,
wobei mindestens ein Teil des Pufferspeichers unterhalb der Erdoberfläche angeordnet ist.

7. Ladesystem gemäß einem der Ansprüche 1 bis 6,
wobei der Ladeanschluss eine Kältemittelleitung aufweist, welche mit dem Kältemittelspeicher gekoppelt ist, zur aktiven Kühlung des Ladeanschlusses.

8. Ladesystem gemäß einem der Ansprüche 1 bis 7,
wobei der Kältemittelspeicher ein Fassungsvermögen von mindestens 100 Litern pro Ladeanschluss aufweist.

9. Ladesystem gemäß Anspruch 3,
wobei der mindestens eine Ladeanschluss an der Ladesäule angeordnet ist und in einer Verbindungsleitung zwischen der Ladesäule und der Ladestation eine Kältemittelleitung angeordnet ist, welche mit dem Kältemittelspeicher gekoppelt ist, zur aktiven Kühlung der Verbindungsleitung.

10. Ladesystem gemäß Anspruch 1 bis 9,
wobei das Kältemittel des Kühlsystems auch zum Heizen benutzt werden kann, sodass das Kühlsystem ein Temperiersystem darstellt.
